# EUROPEAN PATENT APPLICATION

(11) **EP 4 704 540 A1**
(43) Date of publication of application: **04.03.2026**
(21) Application number: 25191701.9
(22) Date of filing: 24.07.2025
(51) Int. Cl.: H10N 60/01, H10N 60/80, H10N 60/12, H10N 69/00

(54) **QUANTUM DEVICE AND METHOD OF MANUFACTURING QUANTUM DEVICE**

(30) Priority: 29.08.2024 JP 2024147951
(71) Applicant: Fujitsu Limited, Kawasaki-shi, Kanagawa 211-8588 (JP)
(72) Inventor: YAMAGUCHI, Junichi, Kawasaki-shi, 211-8588 (JP)
(74) Representative: Haseltine Lake Kempner LLP

(57) **Abstract**

A first superconductor film (12), a second superconductor film (13), a first insulator film (14), and a third superconductor film (15) each having a cubic crystal structure are sequentially formed on a (100) plane or a (111) plane of a substrate (11) having a cubic crystal structure by an epitaxial growth method. The second superconductor film (13), the first insulator film (14), and the third superconductor film (18) are patterned to form a stack (20) including the second superconductor film (13), the first insulator film (14), and the third superconductor film (15). The first superconductor film (12) is patterned using the stacked body (20) as a mask. After the first superconductor film (12) is patterned, a side surface of the stack (20) is wet etched. A second insulator film covering the side surface of the wet etched stack (20) is formed. After the second insulator film is formed, a fourth superconductor film in contact with the third superconductor film (15) is formed.

## Description

### FIELD

The disclosed technology relates to a quantum device and a method of manufacturing the quantum device.

### BACKGROUND

Various methods have been proposed for quantum bits constituting a quantum computer. Among them, superconducting quantum bits based on solid materials are leading research and development. Superconducting quantum bits are energetically researched and developed by research organizations and companies in various countries because quantum coherence which is a macroscopic quantum phenomenon of a superconductor and integrated technology which is a solid-state device are compatible with each other.

As a technique related to a superconducting quantum bit having a Josephson junction, the following technique is known. For example, Patent Document 1 describes that a silicon substrate oriented in a plane parallel to a main surface is subjected to a hydrogen termination treatment, hydrogen is removed by performing first heating on the silicon substrate subjected to the hydrogen termination treatment, a titanium nitride layer is formed on the silicon substrate by a sputtering method while performing second heating on the silicon substrate after hydrogen removal, and a superconducting tunnel junction layer including a plurality of layers including a niobium nitride layer connected to the titanium nitride layer is formed on the titanium nitride layer.

Patent Document 2 describes a chip surface based device structure including a transmon qubit with a vertical Josephson junction including a first superconducting material, a tunnel barrier, and a second superconducting material positioned in a via of a crystal substrate, and a capacitor.

Patent Document 3 describes a vertical Josephson junction device including an epitaxial stack formed on a substrate, a first superconducting electrode embedded in the epitaxial stack, and a second superconducting electrode embedded in the epitaxial stack. The second superconducting electrode is separated from the first superconducting electrode by a dielectric layer, and the first superconducting electrode, the dielectric layer, and the second superconducting electrode form a vertical Josephson junction.

### Related Patent Documents

Patent Document 1: Japanese Patent Application Laid-Open (JP-A) No. 2016-213363
Patent Document 2: Japanese Patent Application Laid-Open (JP-A) No. 2021-518654
Patent Document 3: US 2021/0320240 A

### SUMMARY

Large scale integration of superconducting quantum bits requires an element structure and an integration technology for preventing shortening of lifetime of individual quantum bits and suppressing characteristic variation between quantum bits. An object of the disclosed technology is to manufacture a more accurate Josephson junction in a quantum device.

According to an aspect of the embodiments, a method of manufacturing a quantum device includes the following steps. A step of sequentially forming a first superconductor film, a second superconductor film, a first insulator film, and a third superconductor film each having a cubic crystal structure on a (100) plane or a (111) plane of a substrate having a cubic crystal structure by an epitaxial growth method. A step of forming a stack including the second superconductor film, the first insulator film, and the third superconductor film by patterning the second superconductor film, the first insulator film, and the third superconductor film. A step of patterning the first superconductor film using the stack as a mask. A step of wet etching a side surface of the stack after patterning the first superconductor film. A step of forming a second insulator film covering the wet etched side surface of the stack. A step of forming a fourth superconductor film in contact with the third superconductor film after forming the second insulator film. The stack forms a Josephson junction, and the first superconductor film has a lattice constant of a magnitude between a lattice constant of the substrate and a lattice constant of the second superconductor film.

### BRIEF DESCRIPTION OF THE DRAWINGS

Fig. 1A is a plan view illustrating an example of a configuration of a quantum device according to an embodiment of the disclosed technology;
Fig. 1B is a cross-sectional view taken along line 1B-1B in Fig. 1A;
Fig. 2A is a plan view illustrating an example of a method of manufacturing the quantum device according to the embodiment of the disclosed technology;
Fig. 2B is a cross-sectional view taken along line 2B-2B in Fig. 2A;
Fig. 3A is a plan view illustrating an example of a method of manufacturing the quantum device according to the embodiment of the disclosed technology;
Fig. 3B is a cross-sectional view taken along line 3B-3B in Fig. 3A;
Fig. 4A is a plan view illustrating an example of a method of manufacturing the quantum device according to the embodiment of the disclosed technology;
Fig. 4B is a cross-sectional view taken along line 4B-4B in Fig. 4A;
Fig. 5A is a plan view illustrating an example of a method of manufacturing the quantum device according to the embodiment of the disclosed technology;
Fig. 5B is a cross-sectional view taken along line 5B-5B in Fig. 5A;
Fig. 6A is a plan view illustrating an example of a method of manufacturing the quantum device according to the embodiment of the disclosed technology;
Fig. 6B is a cross-sectional view taken along line 6B-6B in Fig. 6A;
Fig. 7 is a perspective view illustrating a schematic configuration of a single crystal epitaxial stacked structure according to an embodiment of the disclosed technology;
Fig. 8 is a perspective view illustrating a schematic configuration of a single crystal epitaxial stacked structure according to another embodiment of the disclosed technology;
Fig. 9 is a cross-sectional view illustrating a structure in the vicinity of an interface between a substrate and a first superconductor film;
Fig. 10 is a plan view illustrating an example of a configuration of a superconducting quantum circuit according to an embodiment of the disclosed technology;
Fig. 11 is an enlarged view of one of basic units illustrated in Fig. 8;
Fig. 12 is an equivalent circuit diagram of an arithmetic block according to an embodiment of the disclosed technology;
Fig. 13 is a plan view illustrating an example of a quantum bit pattern according to an embodiment of the disclosed technology; and
Fig. 14 is a cross-sectional view illustrating an example of an implementation form of the superconducting quantum circuit according to the embodiment of the disclosed technology.

### DESCRIPTION OF EMBODIMENTS

Hereinafter, an example of an embodiment of the disclosed technology will be described with reference to the drawings. In the drawings, the same or equivalent components and portions are denoted by the same reference numerals, and redundant description is omitted.

### [First Embodiment]

A superconducting quantum bit is constituted by a transmon which is an LC resonance circuit including a Josephson junction element of a nonlinear inductor and a capacitor. At least two levels of non-equidistant discrete energy levels of the transmon are used as quantum bits. One of factors that limit the lifetime (quantum coherence time) of the superconducting quantum bit is a two-level system (TLS) defect that induces fluctuations of charge and critical current in an element or a circuit. It is considered that the TLS defect is generated due to a dangling bond or an impurity defect inside an insulator film constituting the Josephson junction element, a surface oxide of the Josephson junction element, contamination by an oxide or an impurity at an interface between the Josephson junction element and an electrode material, or the like.

As a component of a general Josephson junction element, there is an Al/AlO_{X}/Al three-layer film structure in which an AlO_{X} film is sandwiched between two Al thin films. A method called shadow deposition is used for manufacturing a Josephson junction element using this Al/AlO_{X}/Al three-layer film structure. In the shadow deposition method, a resist mask opened in a crossbar shape is formed in advance on a substrate by lithography. Subsequently, the Al film of the first layer from one direction of the crossbar is deposited obliquely with respect to a substrate surface, and a surface of the Al film of the first layer is oxidized in an O₂ atmosphere to form an AlO_{X} film. Subsequently, the Al film of the second layer is vapor-deposited obliquely with respect to the substrate surface from the direction in which the crossbar is rotated by 90 degrees. As described above, oblique vapor deposition of Al is performed twice in different directions using the shadow of a sidewall of the resist mask, so that an Al/AlO_{X}/Al three-layer film structure is formed at an intersection portion of the crossbar. The shadow vapor deposition method is widely used because a three-layer film structure can be easily obtained, but the Al film becomes polycrystalline and the AlO_{X} film becomes amorphous.

In the Josephson junction element formed by the shadow deposition, in particular, amorphous AlO_{X} films with random crystallinity contain many TLS defects. The conventional Josephson junction element often has a structure in which the Al film on the surface is exposed during or after manufacturing. This structure causes factors that induce TLS defects such as formation of amorphous AlO_{X} by natural oxidation of the Al film surface, adsorption of impurity molecules in the atmosphere, and remaining of resist used in the manufacturing process. In a case where the Al film of the Josephson junction element is polycrystalline, it is difficult to control the grain size and the crystal orientation thereof, and uniformity of film quality of the AlO_{X} film formed on the Al film is also affected. Non-uniformity of film quality of each film constituting the Josephson junction element can also cause variations in characteristics between elements. The disclosed technology is to suppress occurrence of TLS defects and variations in characteristics in a quantum device having a Josephson junction.

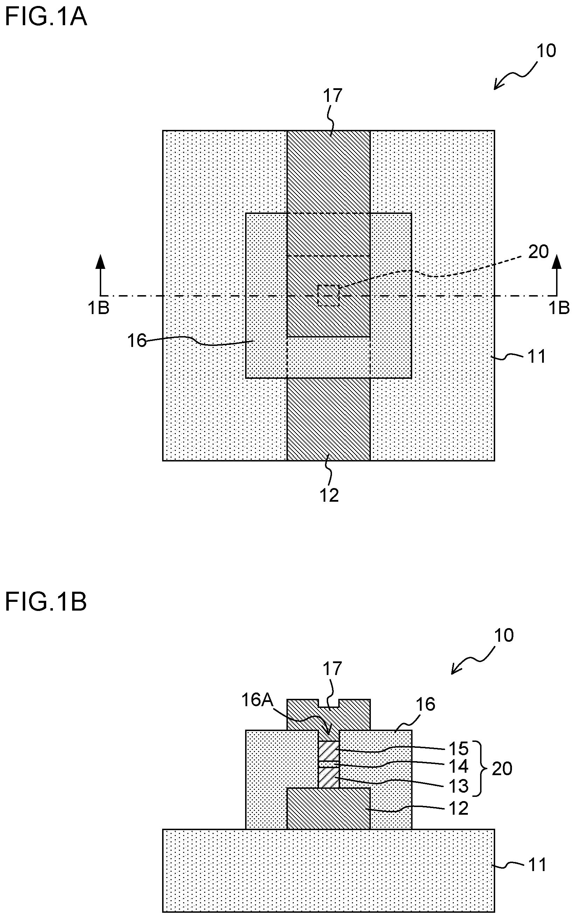

Fig. 1A is a plan view illustrating an example of a configuration of a quantum device 10 according to the embodiment of the disclosed technology. Fig. 1B is a cross-sectional view taken along line 1B-1B in Fig. 1A. The quantum device 10 constitutes a Josephson junction element. The quantum device 10 includes a substrate 11, a first superconductor film 12, a second superconductor film 13, a first insulator film 14, a third superconductor film 15, a second insulator film 16, and a fourth superconductor film 17. Each of the first superconductor film 12, the second superconductor film 13, the third superconductor film 15, and the fourth superconductor film 17 exhibits superconduction at a temperature equal to or lower than a predetermined critical temperature.

The substrate 11 has a cubic crystal structure. The substrate 11 may be, for example, a single-crystal Si substrate. On a (100) plane which is a main surface of the substrate 11, the first superconductor film 12, the second superconductor film 13, the first insulator film 14, and the third superconductor film 15 each having a cubic crystal structure are sequentially formed by an epitaxial growth method. That is, a [100] direction of each of the first superconductor film 12, the second superconductor film 13, the first insulator film 14, and the third superconductor film 15 is parallel to a [100] direction of the substrate 11. A [001] direction of each of the first superconductor film 12, the second superconductor film 13, the first insulator film 14, and the third superconductor film 15 is parallel to a [001] direction of the substrate 11. The first superconductor film 12, the second superconductor film 13, the first insulator film 14, and the third superconductor film 15 are formed by a vacuum consistent process of continuously forming these films while holding the substrate 11 in a vacuum chamber. As a method of forming these films, a physical deposition method is used.

The first superconductor film 12 functions as a lower line of the superconducting quantum circuit and also functions as a buffer layer that alleviates lattice mismatch between the substrate 11 and the second superconductor film 13. That is, the first superconductor film 12 has a lattice constant having a magnitude between a lattice constant of the substrate 11 and a lattice constant of the second superconductor film 13. When the substrate 11 is, for example, a Si substrate (a = 0.5430 nm) and the second superconductor film 13 is, for example, an Al film (a = 0.404 nm), the first superconductor film 12 may be, for example, a TiN film (a = 0.424 nm). When the Al film is directly formed on a surface of the Si substrate, the lattice mismatch degree is 26%. By providing the TiN film between the Si substrate and the Al film, the lattice irregularity can be reduced to 4.7%. Thus, it is possible to enhance crystallinity of a stack (hereinafter, referred to as a JJ stack 20) forming the Josephson junction including the second superconductor film 13, the first insulator film 14, and the third superconductor film 15. The first superconductor film 12 only needs to be a superconductor film having a cubic crystal structure and having a lattice mismatch degree with the JJ stack 20 of less than 10%. As the film satisfying the above conditions, a NbN film or a TaN film can be used in addition to the TiN film.

The JJ stack 20 including the second superconductor film 13, the first insulator film 14, and the third superconductor film 15 is provided on the (100) plane which is the main surface of the first superconductor film 12. The JJ stack 20 has a configuration in which an ultrathin insulator film is sandwiched between two superconductor films, thereby forming a Josephson junction. Each of the second superconductor film 13 and the third superconductor film 15 may be, for example, an Al film. The first insulator film 14 may be, for example, an AlN film.

The second insulator film 16 covers a side surface of the JJ stack 20. The second insulator film 16 functions as a protective layer that protects the JJ stack 20 by including the JJ stack 20. The second insulator film 16 also covers a part of an upper surface and a side surface of the first superconductor film 12. The second insulator film 16 has an opening 16A that exposes an upper surface of the JJ stack 20 (third superconductor film 15). The second insulator film 16 is not necessarily a single crystalline film, and may be a polycrystalline film or an amorphous film. The second insulator film 16 may be, for example, an AlN film.

The fourth superconductor film 17 is in contact with an upper surface of the third superconductor film 15 exposed at the opening 16A of the second insulator film 16. The fourth superconductor film 17 functions as an upper line of the superconducting quantum circuit and also functions as a cap layer covering the upper surface of the JJ stack 20. When the fourth superconductor film 17 is patterned by lift-off using a resist, it is preferable to form the fourth superconductor film 17 at room temperature in order to avoid a change in the shape of the resist. In this case, the fourth superconductor film 17 preferably has a film quality exhibiting a superconducting transition even in film formation at room temperature. As the fourth superconductor film 17, for example, a NbTiN film, a Nb film, a Ta film, or a NbN film can be used.

The JJ stack 20 is completely sealed by the second insulator film 16 covering the side surface thereof and the fourth superconductor film 17 covering the upper surface thereof. Therefore, the JJ stack 20 is not exposed to the atmosphere, and the risk of natural oxidation and impurity adsorption is suppressed.

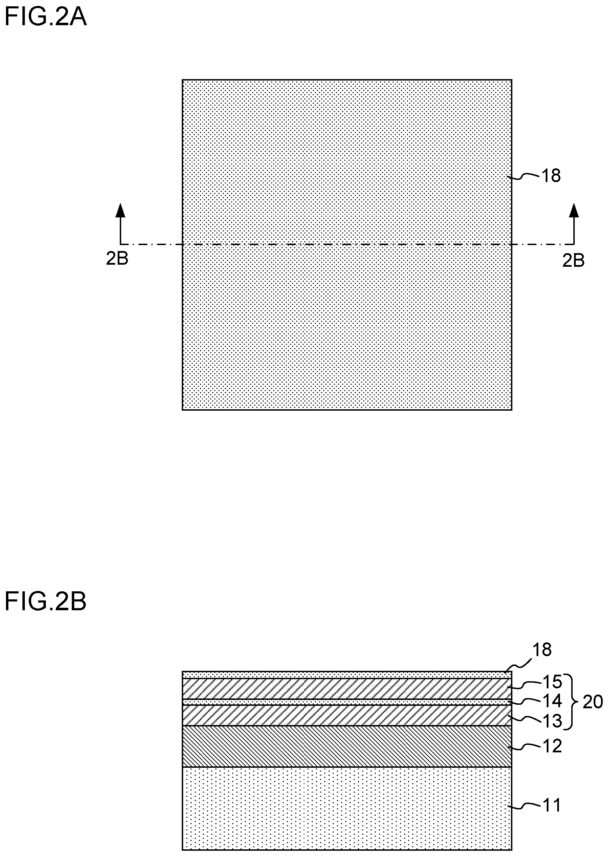

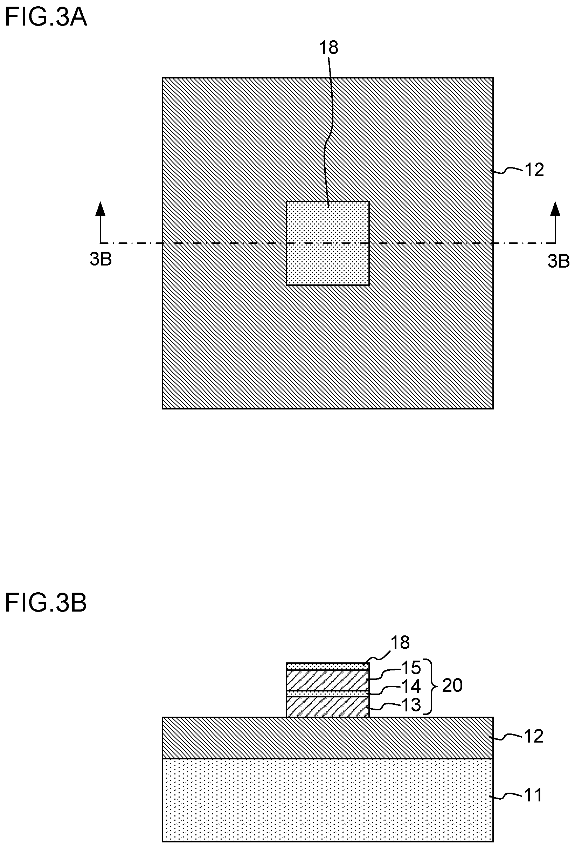

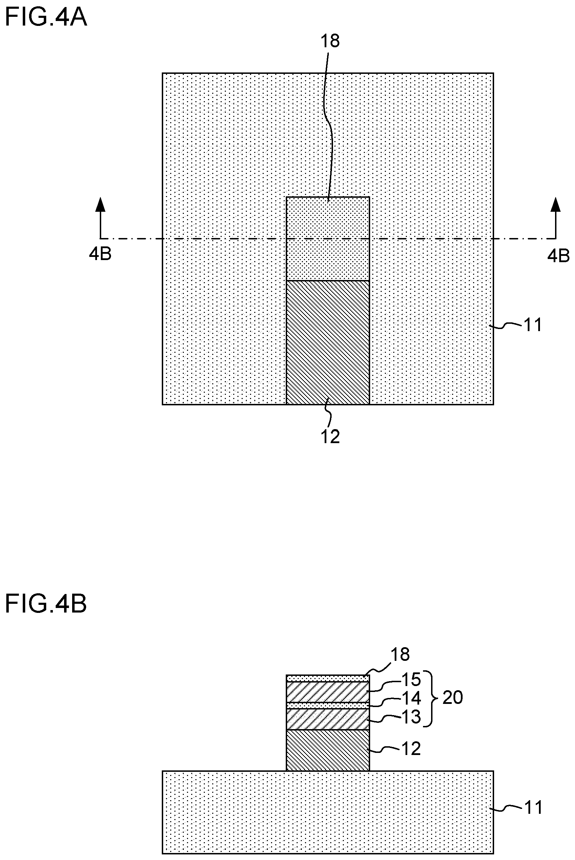

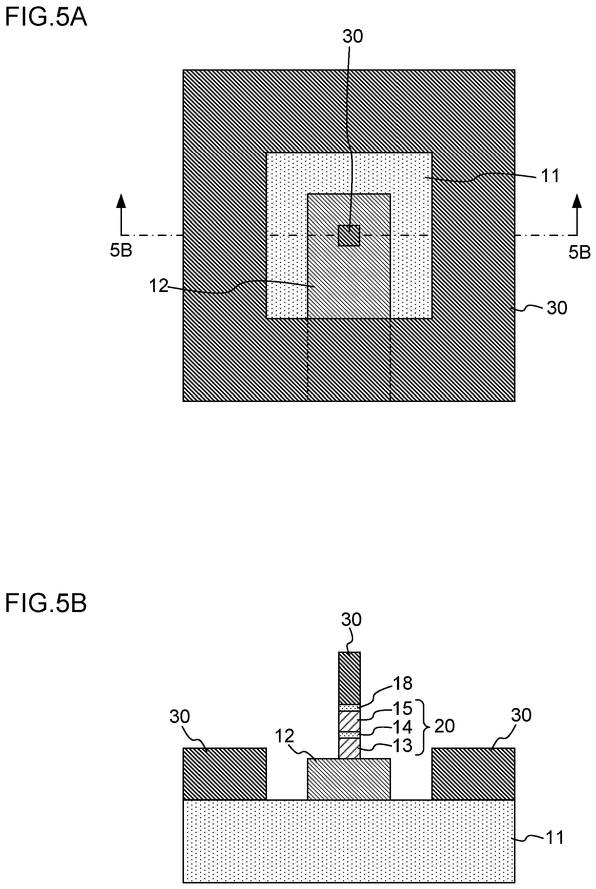

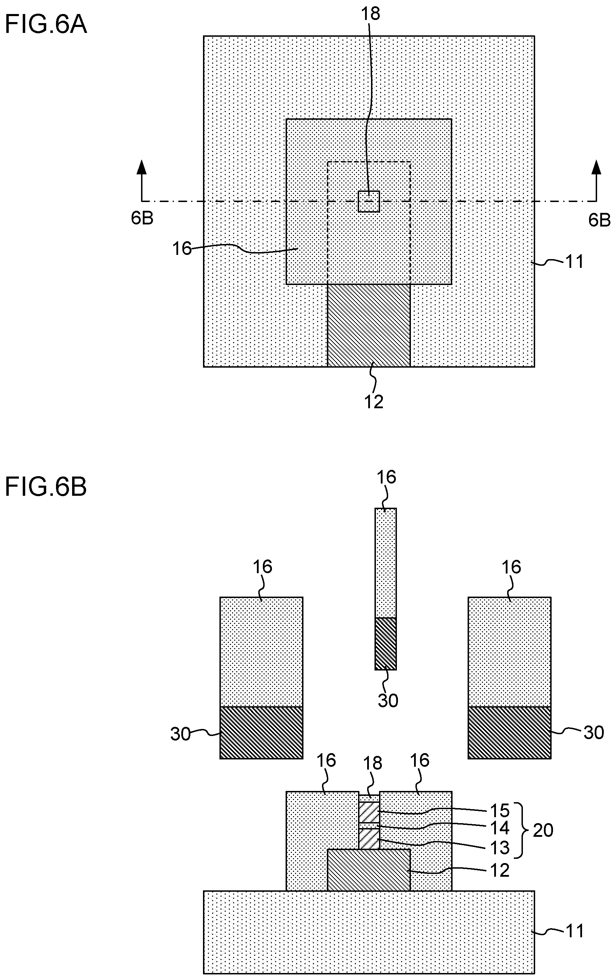

Hereinafter, a method of manufacturing a quantum device will be described. Figs. 2A, 3A, 4A, 5A, and 6A are plan views each illustrating an example of a method of manufacturing the quantum device 10. Fig. 2B is a cross-sectional view taken along line 2B-2B in Fig. 2A. Fig. 3B is a cross-sectional view taken along line 3B-3B in Fig. 3A. Fig. 4B is a cross-sectional view taken along line 4B-4B in Fig. 4A. Fig. 5B is a cross-sectional view taken along line 5B-5B in Fig. 5A. Fig. 6B is a cross-sectional view taken along line 6B-6B in Fig. 6A.

### <Surface treatment of substrate>

The substrate 11 having a cubic crystal structure is prepared. Here, a case where a Si (100) substrate is used as the substrate 11 will be exemplified. The Si (100) substrate is immersed in acetone, and subsequently immersed in isopropyl alcohol to perform ultrasonic cleaning. Thereafter, the substrate is immersed in 5% hydrofluoric acid for 5 minutes, and finally rinsed with ultrapure water. Through these treatments, the natural oxide film on the surface of the Si (100) substrate is removed, and a stable Si surface state in which Si is terminated with H is formed. Next, the Si (100) substrate subjected to the above treatment is rapidly introduced into a vacuum chamber having an ultra-high vacuum degree (basic vacuum degree: 10 on the order of -8 Pa), and degassed by heating at 250°C for 3 hours or more. After the degassing treatment, a flushing treatment of raising the temperature of the Si (100) substrate to 1000°C or higher for several seconds is repeated 2 to 3 times while maintaining the degree of vacuum at the order of 10⁻⁶ Pa. By the flushing treatment, the natural oxide film remaining on the Si (100) substrate surface is removed, and a Si (100)-2 x 1 reconstituted surface with further improved flatness at an atomic level is obtained.

### <Formation of first superconductor film>

Next, the first superconductor film 12 constituting the lower line of the superconducting quantum circuit is formed on the (100) plane which is the main surface of the Si (100) substrate subjected to the surface treatment by an epitaxial growth method. Thus, the first superconductor film 12 is formed on the (100) plane of the substrate 11 with the crystal orientation aligned with respect to the substrate 11 (Figs. 2A and 2B). Here, a case where a TiN (100) film (crystal structure: NaCl type, a = 0.424 nm) is used as the first superconductor film 12 will be exemplified.

The TiN (100) film can be formed by, for example, a pulsed laser deposition (PLD) method. Specifically, for example, the TiN (100) film is formed on the Si (100) substrate held at, for example, 950°C in a vacuum chamber into which a N₂ gas having a flow rate of 3 sccm is introduced and the total pressure of which is controlled to, for example, about 5 × 10⁻² Pa. In the PLD, the TiN (100) film is formed by irradiating a TiN sintered body target arranged to face a position about 5 cm away from the Si (100) substrate with a pulse laser (for example, energy density: 2.0 J/cm², frequency: 1 Hz) to generate a plume. A film formation rate is set to, for example, about 1.5 nm/min, and a TiN (100) film having a film thickness of, for example, about 100 nm is formed.

The method of forming a TiN (100) film is not limited to the PLD method, and a molecular beam epitaxy (MBE) method, a sputtering method, or the like can also be used. As the first superconductor film 12, a NbN (100) film (crystal structure: NaCl type, a = 0.445 nm) or a TaN (100) film (crystal structure: NaCl type, a = 0.442 nm) having a cubic crystal structure and having a lattice mismatch degree with the JJ stack 20 of less than 10% can also be used.

### <Deposition of JJ Stack>

Next, the second superconductor film 13, the first insulator film 14, and the third superconductor film 15 are sequentially formed on the (100) plane which is the main surface of the TiN (100) film by an epitaxial growth method. Thus, the JJ stack 20 is formed on the (100) plane of the first superconductor film 12 with the crystal orientation aligned with respect to the first superconductor film 12 (Figs. 2A and 2B). Here, a case where an Al (100) film (crystal structure: fcc, a = 0.404 nm) is used as the second superconductor film 13 and the third superconductor film 15, and an AlN (100) film (crystal structure: NaCl type, a = 0.407 nm) is used as the first insulator film 14 will be exemplified.

The AL (100) film as the second superconductor film 13 can be formed by, for example, an MBE method. Specifically, for example, in a vacuum chamber controlled to be lower than 10⁻⁶ Pa, an AL (100) film is formed by electron beam deposition on the Si (100) substrate with the TiN (100) film held at, for example, 100°C. A film formation rate is set to, for example, about 20 nm/min, and an Al (100) film having a film thickness of, for example, about 50 nm is formed.

The substrate temperature at the time of Al film formation is preferably selected between -50°C and 400°C. By heating the substrate, kinetic energy for migration of the Al evaporated particles on the surface of the substrate can be provided. The substrate temperature is preferably adjusted according to the film formation rate. For example, when the film formation rate is low and the kinetic energy of the Al evaporated particles is not sufficient, the substrate temperature is preferably set to be high so that two-dimensional epitaxial growth of the Al (100) film is promoted.

When an Al film is directly formed on the Si (100) substrate, since the lattice mismatch degree between Al and Si increases to 26%, the Al film is formed in a polycrystalline state. When an Al film is formed with a TiN (100) film sandwiched between the Al film and the Si (100) substrate, lattice mismatch between Al and TiN is as small as 4.7%, and epitaxial growth of the Al (100) film becomes possible. That is, the TiN (100) film as the first superconductor film 12 that functions as the lower line also functions as a buffer layer that alleviates lattice mismatch between the Si (100) substrate as the substrate 11 and the Al (100) film as the second superconductor film 13.

Subsequently, an AlN (100) film as the first insulator film 14 is formed on the (100) plane which is the main surface of the Al (100) film as the second superconductor film 13. The AlN (100) film can be formed by, for example, a PLD method. Specifically, for example, an AlN (100) film is formed on the Si (100) substrate with the Al (100) film/TiN (100) film held at, for example, 100°C in a vacuum chamber into which a N₂ gas at a flow rate of 3 sccm is introduced and in which the total pressure is controlled to, for example, about 5 × 10⁻² Pa. In the PLD, the AlN (100) film is formed by irradiating an AlN sintered body target arranged to face a position about 5 cm away from a Si (100) substrate with a pulse laser (for example, energy density: 1.0 J/cm², frequency: 1 Hz) to generate a plume. The film formation rate is set to, for example, about 0.5 nm/min, and an AlN (100) film having a film thickness of, for example, about 1.5 nm is formed.

Subsequently, the Al (100) film as the third superconductor film 15 is formed on the (100) plane which is the main surface of the AlN (100) film as the first insulator film 14. The AL (100) film as the third superconductor film 15 can be formed by, for example, the MBE method, similarly to the Al (100) film as the second superconductor film 13. Also here, the film formation rate is set to, for example, about 20 nm/min, and an Al (100) film having a film thickness of, for example, about 50 nm is formed.

### <Formation of third insulator film>

Next, a third insulator film 18 is formed on the (100) plane, which is the main surface of the third superconductor film 15, by an epitaxial growth method. Thus, the third insulator film 18 is formed on the (100) plane of the third superconductor film 15 with a crystal orientation aligned with respect to the third superconductor film 15 (Figs. 2A and 2B). Here, a case where an AlN (100) film (crystal structure: NaCl type, a = 0.407 nm) is used as the third insulator film 18 will be exemplified. The AlN (100) film can be formed by, for example, a PLD method. The film thickness of the AlN (100) film is set to about 10 nm. The third insulator film 18 functions as a protective layer that protects the upper surface of the JJ stack 20.

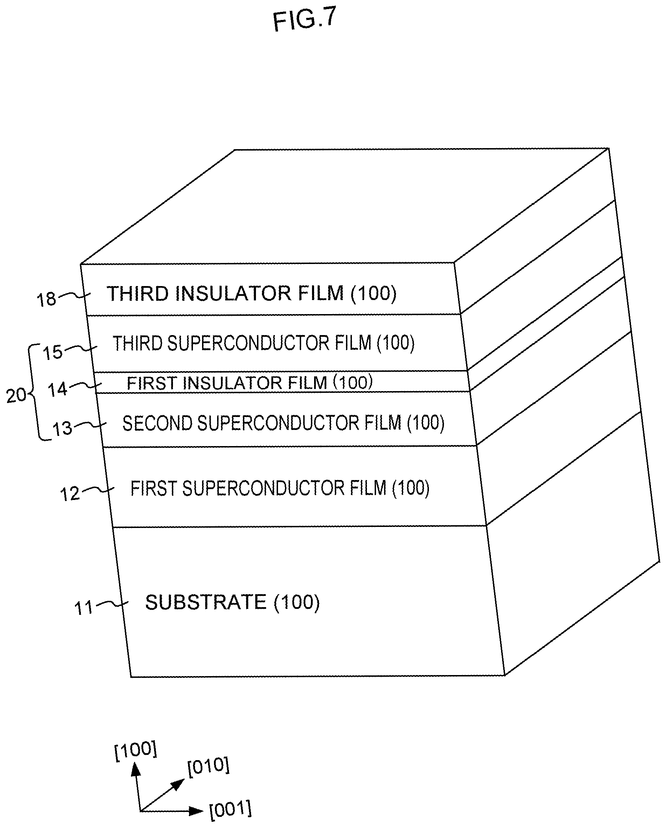

Fig. 7 is a perspective view illustrating a schematic configuration of a single crystal epitaxial stacked structure obtained through the above steps. Each of the substrate 11, the first superconductor film 12, the second superconductor film 13, the first insulator film 14, the third superconductor film 15, and the third insulator film 18 has a cubic crystal structure. Each film formed on the (100) plane of the substrate 11 is formed by an epitaxial growth method. That is, the [100] direction of each of the first superconductor film 12, the second superconductor film 13, the first insulator film 14, the third superconductor film 15, and the third insulator film 18 is parallel to the [100] direction of the substrate. The [001] direction of each of the first superconductor film 12, the second superconductor film 13, the first insulator film 14, the third superconductor film 15, and the third insulator film 18 is parallel to the [001] direction of the substrate. The deposition of the first superconductor film 12, the second superconductor film 13, the first insulator film 14, the third superconductor film 15, and the third insulator film 18 is performed by a vacuum integrated process of continuously depositing these films while holding the substrate 11 in a vacuum chamber.

### <Etching 1 of JJ stack>

Next, the JJ stack 20 is partially etched to expose the first superconductor film 12 (Figs. 3A and 3B). Specifically, the JJ stack 20 and the third insulator film 18 covering the JJ stack are processed into an island shape having a size (several tens of micrometers square) sufficiently larger than the final size (several hundreds of nanometers square) of the JJ stack 20 by photolithography and dry etching.

A resist (not illustrated) applied to the surface of the substrate 11 by a spin coating method is patterned in an island shape of, for example, 20 µm square by photolithography. Next, the second superconductor film 13 (Al film), the first insulator film 14 (AlN film), the third superconductor film 15 (Al film), and the third insulator film 18 (AlN film) are etched by dry etching by reactive ion etching (RIE), thereby processing the JJ stack 20 into, for example, a 20 µm square island pattern.

In the RIE, for example, a BCl₃ gas is introduced as a reaction gas to control the total pressure to, for example, 10 Pa, and high frequency power is set to, for example, 100 W. According to the RIE using the BCl₃ gas, since the selection ratio of the AlN/Al/AlN/Al film to the TiN film can be increased, it is possible to etch the AlN/Al/AlN/Al film almost without etching the TiN film. By etching the JJ stack 20 and the third insulator film 18, the surface of the first superconductor film 12 is exposed. The etching in this step is not limited to dry etching, and may be wet etching.

### <Patterning of first superconductor film>

Next, the exposed TiN film as the first superconductor film 12 is patterned by etching (Fig. 4A, Fig. 4B). Specifically, the TiN film is patterned by dry etching using RIE to form a lower line of the superconducting quantum circuit. In the RIE, a CF₄ gas is introduced as a reaction gas to control the total pressure to, for example, 10 Pa, and the high frequency power is set to, for example, 100 W.

### <Etching 2 of JJ stack>

Next, the JJ stack 20 is patterned by wet etching (Figs. 5A and 5B). That is, by performing the second etching on the JJ stack 20 and the third insulator film 18 by wet etching, the JJ stack 20 is finely processed to a final size (several hundreds of nanometers square).

A resist 30 is spin-coated on the surface of the substrate 11, and an island-shaped mask pattern of, for example, 150 nm square corresponding to the final pattern of the JJ stack 20 is formed on the resist 30 by electron beam lithography. The resist 30 is used not only as a mask for wet etching of the JJ stack 20 in this step but also as a mask for patterning the second insulator film 16 by lift-off in a later step. Therefore, the mask pattern of the resist 30 also corresponds to the pattern of the second insulator film 16. The resist 30 may be a two-layer resist. The two-layer resist can form an overhang structure in which an end portion of an upper layer resist protrudes with respect to a lower layer resist. This facilitates lift-off of the second insulator film 16. For example, ZEP520A-7 (manufactured by Zeon Corporation) can be used as the upper layer resist, and for example, Copolymer MMA (8.5) MMA EL11 (manufactured by Kayaku Advanced Materials Corporation, Inc) can be used as the lower layer resist. As an etchant for wet etching of the JJ stack 20 and the third insulator film 18, for example, a mixed acid aqueous solution (H₃PO₄:HNO₃:CH₃COOH:H₂O = 74:3:3: 20%) can be used. The JJ stack 20 and the third insulator film 18 are subjected to wet etching, and then rinsed with ultrapure water. The resist 30 used in this step proceeds to the next step without being removed.

Here, in a case where the film formation of the JJ stack 20 is performed by the conventional shadow deposition using a resist mask opened in a crossbar shape, etching for patterning the JJ stack 20 is unnecessary. Since the film formation of the JJ stack 20 according to the present embodiment is performed by an epitaxial growth method, etching for patterning the JJ stack 20 is required. In the present embodiment, as described above, patterning of the JJ stack 20 is performed by two times of etching, and the second etching is performed by wet etching. The patterning of the JJ stack 20 is performed by two times of etching because it is difficult to perform fine processing of the JJ stack by only one time of etching. The JJ stack 20 is roughly processed by first etching (RIE) to cut out a small piece, and processed to a final size by second etching (wet etching), whereby a fine pattern can be formed. By performing wet etching as the second etching, it is possible to remove residues adhering to side walls of the JJ stack 20.

### <Formation of second insulator film>

Next, the second insulator film 16 covering the side surface of the JJ stack 20 is formed (Fig. 6A, 6B). Here, a case where an AlN film is used as the second insulator film 16 will be exemplified. The AlN film is formed through the resist 30 used for the wet etching of the JJ stack 20 in the previous step, for example, by the PLD method. Specifically, the AlN film is formed on the substrate 11 with resist held at, for example, 25°C in a vacuum chamber into which N₂ gas is introduced and the total pressure is controlled to, for example, about 5 × 10⁻² Pa. In the PLD, the AlN sintered body target arranged to face a position about 5 cm away from the substrate 11 is irradiated with a pulse laser (for example, energy density: 2.0 J/cm², frequency: 10 Hz) to generate a plume, thereby forming an AlN film. The film formation rate is set to, for example, about 25 nm/min, and an AlN film having a film thickness of, for example, about 250 nm is formed. The AlN film as the second insulator film 16 is not necessarily a single crystalline film, and may be a polycrystalline film or an amorphous film.

The resist 30 has an opening surrounding the periphery of the JJ stack 20, and a portion exposed in the opening is covered with the AlN film. Subsequently, patterning of the AlN film is performed by lift-off for removing the AlN film deposited on the surface of the resist 30 together with the resist 30. The AlN film as the second insulator film 16 covers the side surface of the JJ stack 20 so as to enclose the JJ stack 20. The second insulator film 16 functions as a protective layer that protects the side surface of the JJ stack 20. The JJ stack 20 is completely sealed by two protective layers including the second insulator film 16 and the third insulator film 18.

### <Formation of fourth superconductor film>

Next, the fourth superconductor film 17 in contact with the third superconductor film 15 is formed (Figs. 1A and 1B). Specifically, first, a resist (not illustrated) is applied by spin coating, and a mask pattern is formed on the resist by photolithography. This resist is used as a mask for removing the third insulator film 18 by etching and patterning the fourth superconductor film 17 by lift-off. For the resist, for example, TLOR-P003HP (manufactured by TOKYO OHKA KOGYO CO., LTD.) capable of forming an overhang structure in a single layer can be used.

Next, the substrate 11 is introduced into a vacuum chamber, and the third insulator film 18 is removed by Ar ion milling using the resist as a mask. Thus, the surface of the third superconductor film 15 is exposed. In the Ar ion milling, an Ar gas is introduced into a vacuum chamber, and the total pressure is controlled to be, for example, 5 × 10⁻³ Pa. The ion acceleration voltage is set to, for example, 1.0 kV, and the ion beam current is set to, for example, 100 µA.

After the third insulator film 18 is removed, the fourth superconductor film 17 is formed in the same vacuum chamber without exposing the substrate 11 to the atmosphere. Here, a case where a NbTiN film is used as the fourth superconductor film 17 will be exemplified. The NbTiN film can be formed by, for example, a PLD method. Specifically, the NbTiN film is formed on the substrate 11 with resist held at, for example, 25°C in a vacuum chamber into which N₂ gas is introduced and the total pressure is controlled to, for example, about 5 × 10⁻² Pa. In the PLD, the NbTi sintered body target arranged to face a position about 5 cm away from the substrate 11 is irradiated with a pulse laser (for example, energy density: 2.0 J/cm², frequency: 10 Hz) to generate a plume. NbTi particles are ablated and nitrided under a N₂ atmosphere to form the NbTiN film. A film formation rate is set to, for example, about 20 nm/min, and the NbTiN film having a film thickness of, for example, about 350 nm is deposited.

Subsequently, the NbTiN film is patterned by lift-off for removing the NbTiN film deposited on the surface of the resist together with the resist. As the fourth superconductor film 17, for example, a Nb film, a Ta film, or a NbN film can be used in addition to the NbTiN film. Through the above steps, the quantum device 10 is completed.

In the Josephson junction element formed by the conventional shadow deposition, many TLS defects are included, particularly in amorphous AlO_{X} films with random crystallinity. The conventional Josephson junction element often has a structure in which the Al film on the surface is exposed during or after manufacturing. This structure causes factors that induce TLS defects such as formation of amorphous AlO_{X} by natural oxidation of the Al film surface, adsorption of impurity molecules in the atmosphere, and remaining of resist used in the manufacturing process. In a case where the Al film of the Josephson junction element is polycrystalline, it is difficult to control the grain size and the crystal orientation thereof, and uniformity of film quality of the AlO_{X} film formed on the Al film is also affected. Non-uniformity of film quality of each film constituting the Josephson junction element can also cause variations in characteristics between elements.

By the manufacturing method according to the embodiment of the disclosed technology, the first superconductor film 12, the second superconductor film 13, the first insulator film 14, and the third superconductor film 15 each having a cubic crystal structure are sequentially formed on the (100) plane of the substrate 11 having a cubic crystal structure by an epitaxial growth method. Thus, it is possible to suppress the occurrence of the TLS defect and the characteristic variation caused by disturbance of crystallinity of the second superconductor film 13, the first insulator film 14, and the third superconductor film 15 constituting the JJ stack 20. Since each of the above films is formed by a vacuum integrated process, contamination of impurities can be avoided. This makes it possible to suppress the occurrence of TLS defects due to contamination with impurities.

The side surface of the JJ stack 20 is covered with the second insulator film 16, and the upper surface of the JJ stack 20 is covered with the fourth superconductor film 17. Thus, the JJ stack 20 is not exposed to the atmosphere after production. This makes it possible to suppress temporal variation of element characteristics due to progress of natural oxidation.

The upper surface of the JJ stack 20 is covered with the third insulator film 18 from immediately after the films constituting the JJ stack are formed until the fourth superconductor film 17 is formed. This makes it possible to prevent surface oxidation of the superconducting film and direct adhesion of organic contamination such as a resist by lithography or etching repeatedly performed in the manufacturing process. This makes it possible to suppress the occurrence of TLS defects.

The first superconductor film 12 has a lattice constant having a magnitude between the lattice constant of the substrate 11 and the lattice constant of the second superconductor film 13.

Thus, lattice mismatch between the substrate 11 and the second superconductor film 13 is alleviated, so that the crystallinity of the JJ stack 20 can be improved.

Patterning of the JJ stack 20 is performed by two times of etching. It is possible to form a fine pattern by performing rough processing of cutting out a small piece of the JJ stack 20 by the first etching and processing it to a final size by the second etching. By performing wet etching as the second etching, it is possible to remove residues adhering to the side walls of the JJ stack 20.

### [Second Embodiment]

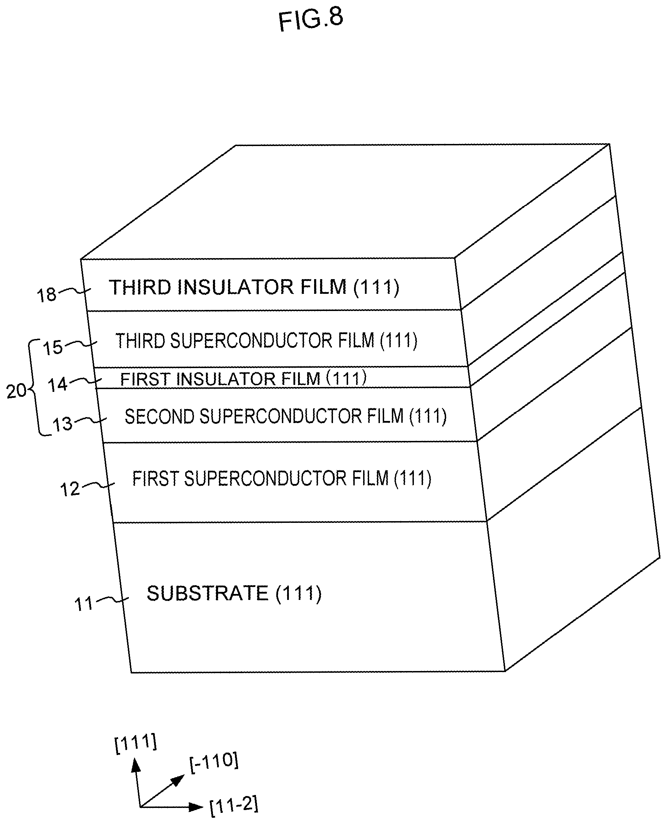

Fig. 8 is a perspective view illustrating a schematic configuration of a single crystal epitaxial stacked structure according to a second embodiment of the disclosed technology. In the single crystal epitaxial stacked structure according to the second embodiment, the crystal orientation of each film formed on the substrate 11 and the substrate 11 is different from that of the single crystal epitaxial stacked structure according to the first embodiment (Fig. 7).

In the single crystal epitaxial stacked structure according to the second embodiment, the first superconductor film 12, the second superconductor film 13, the first insulator film 14, the third superconductor film 15, and the third insulator film 18 are provided on the (111) plane of the substrate 11. A [111] direction of each of the first superconductor film 12, the second superconductor film 13, the first insulator film 14, the third superconductor film 15, and the third insulator film 18 is parallel to the [111] direction of the substrate 11. A [11-2] direction of each of the first superconductor film 12, the second superconductor film 13, the first insulator film 14, the third superconductor film 15, and the third insulator film 18 is parallel to the [11-2] direction of the substrate 11.

The single crystal epitaxial stacked structure according to the second embodiment is obtained through the respective steps of the surface treatment of the substrate 11, the deposition of the first superconductor film 12, the deposition of the JJ stacked body 20, and the formation of the third insulator film 18 as in the first embodiment described above.

In the surface treatment step of the substrate 11, a cleaning treatment, a rinsing treatment, a degassing treatment, and a flushing treatment are sequentially performed on the Si (111) substrate. This results in a Si (111)-7 x 7 reconstructed surface with improved planarity at the atomic level.

In the step of forming the first superconductor film 12, the first superconductor film 12 constituting the lower line of the superconducting quantum circuit is formed on the (111) plane which is the main surface of the substrate 11 subjected to the surface treatment by the epitaxial growth method. Thus, the first superconductor film 12 is formed on the (111) plane of the substrate 11 with the crystal orientation aligned with respect to the substrate 11. The first superconductor film 12 may be, for example, a TiN (111) film.

In the film forming step of the JJ stack 20, the second superconductor film 13, the first insulator film 14, and the third superconductor film 15 are sequentially formed on the (111) plane which is the main surface of the first superconductor film 12 by an epitaxial growth method. Thus, the JJ stack 20 is formed on the (111) plane of the first superconductor film 12 with the crystal orientation aligned with respect to the first superconductor film 12. The second superconductor film 13 and the third superconductor film 15 may be, for example, an Al (111) film, and the first insulator film 14 may be, for example, an AlN (111) film.

In the step of forming the third insulator film 18, the third insulator film 18 is formed on the (111) plane which is the main surface of the third superconductor film 15 by an epitaxial growth method. Thus, the third insulator film 18 is formed on the (111) plane of the third superconductor film 15 with the crystal orientation aligned with respect to the third superconductor film 15. The third insulator film 18 may be, for example, an AlN (111) film.

Thereafter, as in the first embodiment, a quantum device having a structure similar to that of the quantum device 10 (see Figs. 1A and 1B) according to the first embodiment is obtained by passing through the steps of etching the JJ stack 20 (first), patterning the first superconductor film 12, etching the JJ stack 20 (second), formation of the second insulator film 16, and formation of the fourth superconductor film 17.

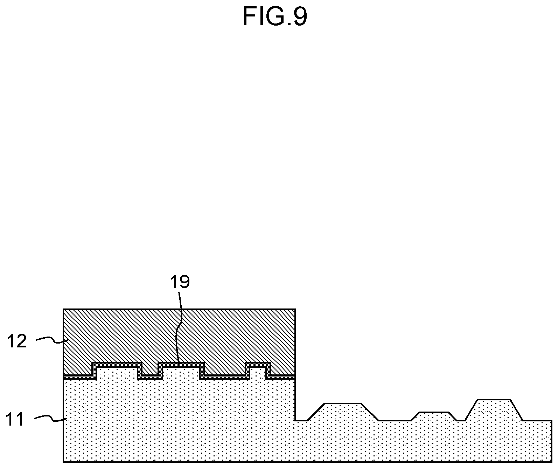

Fig. 9 is a cross-sectional view illustrating a structure near an interface between the substrate 11 and the first superconductor film 12. It has been reported that in an initial process in which a TiN film as the first superconductor film 12 crystal-grows on a Si substrate as the substrate 11, nucleation points 19 of titanium silicide (TiSi_{X}) are formed at a TiN/Si interface in order to alleviate lattice mismatch between TiN and Si (lattice mismatch degree: 22%) (T. Brat et al., J. Vac. Sci. Technol B 5, 1741 (1987)). It is considered that the formation of the nucleation points 19 of TiSi_{X} at the TiN/Si interface enables epitaxial growth of the TiN film on a Si substrate (R. Sun et al., IEEE Trans. Appl. Supercond, 25, 1101204 (2015)).

The nucleation points 19 of TiSi_{X} may also cause a decrease in flatness of the TiN/Si interface (particularly the Si surface side). In the patterning process of the first superconductor film 12, the first superconductor film 12 is partially removed, so that the surface of the substrate 11 with reduced flatness is exposed. A decrease in the flatness of the surface of the substrate 11 may lead to an increase in TLS defects. The substrate 11 is used as a capacitor of a superconducting quantum bit, and when flatness of the substrate 11 decreases, dielectric loss of the superconducting quantum circuit increases, and as a result, a lifetime (quantum coherence time) of the superconducting quantum bit may be limited.

In order to form the TiN film on a Si substrate by an epitaxial growth method, it is necessary to form the nucleation points 19 of TiSi_{X} at the TiN/Si interface, but it is preferable to appropriately suppress the density thereof. The nucleation points 19 of TiSi_{X} is likely to occur in a chemically active crystal plane. In other words, by epitaxially growing the TiN film on the crystal plane having a relatively low surface energy among the crystal planes of Si, the density of the nucleation points 19 of TiSi_{X} can be suppressed. For example, according to a first principle simulation (G.-H. Lu et al., Surface Science 588, 61 (2005)), the surface energy of the Si (100)-2x1 reconstructed surface is 94.1 meV/Å², and the surface energy of the Si (111)-7x7 reconstructed surface is 88.6 meV/Å². By epitaxially growing the TiN film on the (111) plane having the lowest surface energy among the crystal planes of the Si substrate, the density of the nucleation points 19 of TiSi_{X} can be appropriately suppressed.

As described above, the method of manufacturing the quantum device according to the second embodiment includes a step of sequentially forming the first superconductor film 12, the second superconductor film 13, the first insulator film 14, and the third superconductor film 15 each having a cubic crystal structure on the (111) plane of the substrate 11 having a cubic crystal structure by an epitaxial growth method.

According to the method of manufacturing the quantum device according to the second embodiment, it is possible to suppress the density of nucleation points 19 of TiSi_{X}. Thus, flatness of the substrate 11 can be secured, and occurrence of the TLS defect can be suppressed.

In the above description, the nucleation points of TiSi_{X} generated when the first superconductor film 12 is a TiN film has been exemplified, but even when the first superconductor film 12 is a NbN film or a TaN film, nucleation points for alleviating lattice mismatch with the substrate 11 can be generated. Even in this case, it is possible to suppress the density of nucleation points by epitaxially growing the first superconductor film 12 on the (111) plane of the substrate 11.

### [Third Embodiment]

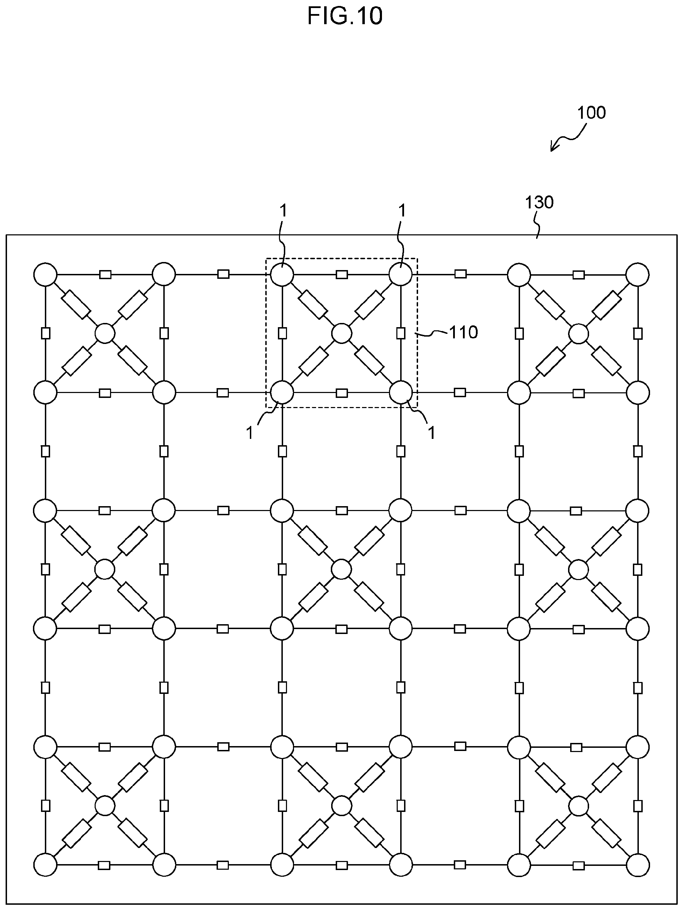

Fig. 10 is a plan view illustrating an example of a configuration of a superconducting quantum circuit 100 according to a third embodiment of the disclosed technology. The superconducting quantum circuit 100 according to the present embodiment has four quantum bits 1 as a basic unit 110. The superconducting quantum circuit 100 has a plurality of basic units 110 arranged in a lattice pattern on the surface of the base material 130. The quantum bit 1 includes a Josephson junction element which is the quantum device 10 according to the first embodiment described above.

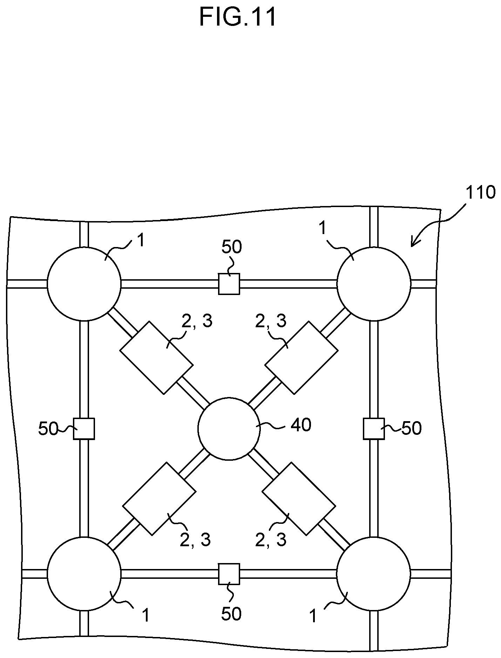

Fig. 11 is an enlarged view of one of the basic units 110 illustrated in Fig. 10. Four quantum bits 1 constituting one basic unit 110 are arranged at positions corresponding to four vertexes of a square, and a reading electrode 40 is arranged at the center of the square. One reading electrode 40 is shared by four quantum bits 1. A resonator 2 and a filter 3 are provided on each path from the four quantum bits 1 to the reading electrode 40. Each quantum bit 1 is connected to another adjacent quantum bit 1 via a capacitor 50. Thus, each quantum bit 1 creates a quantum entangled state with another adjacent quantum bit 1 and performs a quantum operation.

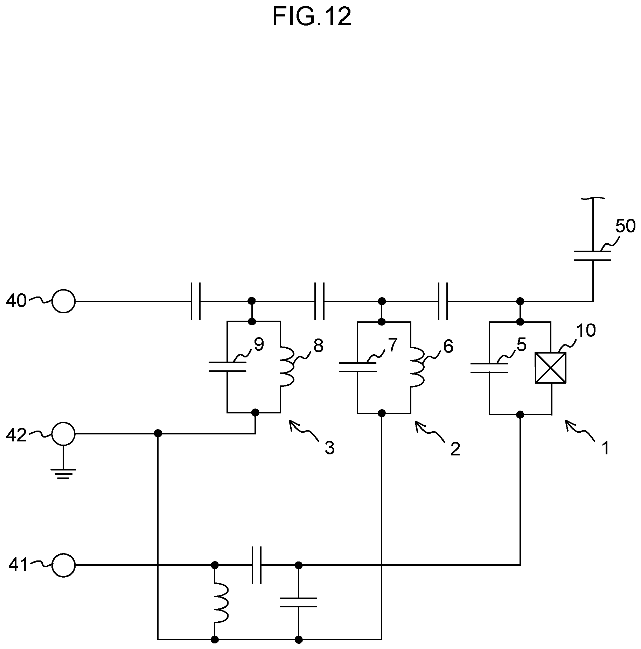

Fig. 12 is an equivalent circuit diagram of an arithmetic block including one quantum bit 1, one resonator 2, and one filter 3. The quantum bit 1 forms a coherent two-level system using superconductivity and performs a quantum operation using nonlinear energy. The quantum bit 1 has a transmon in which a Josephson junction element, which is the quantum device 10 according to the first embodiment described above, and the capacitor 5 are connected in parallel.

The resonator 2 is connected to the quantum bit 1 via a capacitor. The resonator 2 interacts with the quantum bit 1 to read out a response signal indicating the state of the quantum bit 1. The resonator 2 has a resonance circuit in which the superconducting inductor 6 and the capacitor 7 are connected in parallel. The filter 3 is connected to the resonator 2 via a capacitor. The filter 3 suppresses relaxation of the signal having the frequency of the quantum bit 1 to a reading port 14. Similarly to the resonator 2, the filter 3 has a resonance circuit in which the superconducting inductor 8 and the capacitor 9 are connected in parallel.

A control electrode 41, a ground electrode 42, and a reading electrode 40 are connected to the arithmetic block. A control signal for controlling the quantum bit 1 is input to the control electrode 41. In Figs. 10 and 11, illustration of the control electrode 41 and the ground electrode 42 is omitted. The state of the quantum bit 1 is controlled by a control signal input to the control electrode 41. The response signal indicating the state of the quantum bit 1 is read from the reading electrode 40. The ground electrode 42 is connected to an external ground potential. The ground potential applied to the ground electrode 42 is common to the ground of each portion of the arithmetic block.

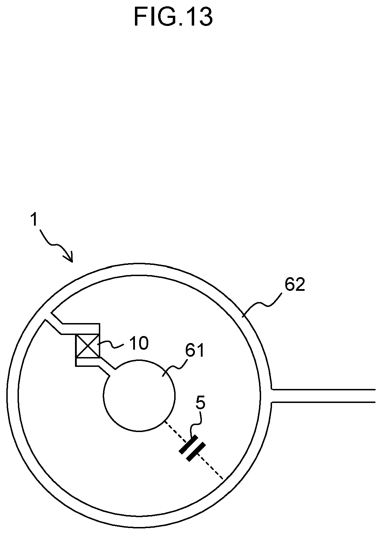

Fig. 13 is a plan view illustrating an example of a pattern of the quantum bit 1. The quantum bit 1 includes a circular inner electrode 61 and an annular outer electrode 62 surrounding the inner electrode 61. That is, the quantum bit 1 has a concentric pattern. The quantum bit 1 includes a quantum device 10 (Josephson junction element) provided between the inner electrode 61 and the outer electrode 62. One of the first superconductor film 12 constituting the lower line of the quantum device 10 and the fourth superconductor film 17 constituting the upper line is connected to the inner electrode 61, and the other is connected to the outer electrode 62. The inner electrode 61 also functions as one electrode of the capacitor 5, and the outer electrode 62 also functions as the other electrode of the capacitor 5. The quantum device 10 (Josephson junction element) and the capacitor 5 connected in parallel between the inner electrode 61 and the outer electrode 62 constitute transmon.

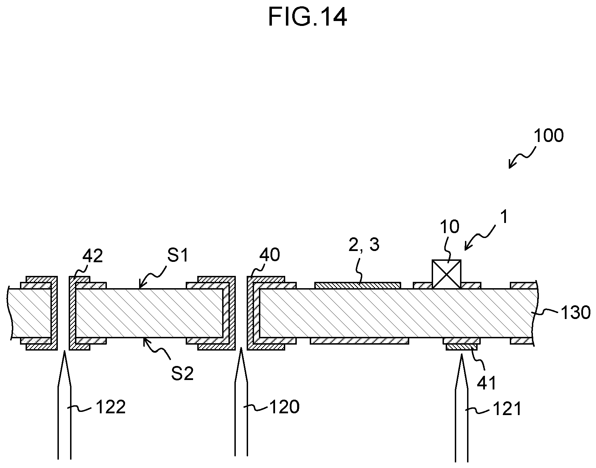

Fig. 14 is a cross-sectional view illustrating an example of an implementation form of the superconducting quantum circuit 100. The superconducting quantum circuit 100 includes, for example, a silicon substrate as the base material 130. The base material 130 may also serve as the substrate 11 of the quantum device 10. The quantum bit 1, the resonator 2, and the filter 3 are provided on a first surface S1 of the base material 130, and the control electrode 41 is provided on a second surface S2 of the base material 130. The control electrode 41 is provided immediately below the quantum bit 1. A control signal input from the control probe 121 in contact with the control electrode 41 acts on the quantum bit 1 via the base material 130. Each of the reading electrode 40 and the ground electrode 42 has a through electrode structure penetrating the base material 130. The response signal output via the resonator 2 and the filter 3 is read by the reading probe 120 abutting on the reading electrode 40 from the side of the second surface S2. A ground potential is applied to each part of the superconducting quantum circuit 100 from the second surface S2 side via the ground probe 122 abutting on the ground electrode 42.

With the superconducting quantum circuit 100 according to the embodiment of the disclosed technology, since the occurrence of the TLS defect and variations in characteristics in the Josephson junction element are suppressed, it is possible to enhance the performance related to the life (quantum coherence time) of the quantum bit 1 and suppress the occurrence of errors.

According to the disclosed technology, it is possible to suppress occurrence of TLS defects and variations in characteristics in a quantum device having a Josephson junction.

With regard to the first and second embodiments described above, the following supplementary notes are further disclosed.

### (Supplementary note 1)

A quantum device, including:
sequentially forming a first superconductor film, a second superconductor film, a first insulator film, and a third superconductor film each having a cubic crystal structure on a (100) plane or a (111) plane of a substrate having a cubic crystal structure by an epitaxial growth method;
forming a stack including the second superconductor film, the first insulator film, and the third superconductor film by patterning the second superconductor film, the first insulator film, and the third superconductor film;
patterning the first superconductor film using the stack as a mask;
wet etching a side surface of the stack after patterning the first superconductor film;
forming a second insulator film covering the wet etched side surface of the stack; and
forming a fourth superconductor film in contact with the third superconductor film after forming the second insulator film, in which
the stack forms a Josephson junction, and
the first superconductor film has a lattice constant of a magnitude between a lattice constant of the substrate and a lattice constant of the second superconductor film.

### (Supplementary note 2)

The manufacturing method according to supplementary note 1, further including:
forming a third insulator film covering a surface of the third superconductor film before forming the stack; and
removing the third insulator film after forming the second insulator film and before forming the fourth superconductor film.

### (Supplementary note 3)

The manufacturing method according to supplementary note 2, in which
the first superconductor film, the second superconductor film, the first insulator film, the third superconductor film, and the third insulator film are continuously formed while the substrate is held in a vacuum chamber.

### (Supplementary note 4)

The manufacturing method according to any one of supplementary notes 1 to 3, in which
a lattice mismatch degree between the first superconductor film and the second superconductor film is less than 10%.

### (Supplementary note 5)

The manufacturing method according to any one of supplementary notes 1 to 4, in which
the substrate is a Si substrate,
the second superconductor film and the third superconductor film are each an Al film, and
the first insulator film is an AlN film.

### (Supplementary note 6)

The manufacturing method according to any one of supplementary notes 1 to 5, in which
the first superconductor film is a TiN film, a NbN film, or a TaN film.

### (Supplementary note 7)

The manufacturing method according to any one of supplementary notes 1 to 6, in which
the second insulator film is an AlN film.

### (Supplementary note 8)

The manufacturing method according to any one of supplementary notes 1 to 7, in which
the fourth superconductor film is a NbTiN film, a Nb film, a Ta film, or a NbN film.

### (Supplementary note 9)

The manufacturing method according to any one of supplementary notes 1 to 8, in which
the second insulator film is formed in a state where a resist (30, Fig. 5B) to be used in wet etching the side surface of the stack is left, and the second insulator film deposited on the resist is removed together with the resist to pattern the second insulator film.

### (Supplementary note 10)

A quantum device including:
a substrate having a cubic crystal structure;
a first superconductor film provided on a (100) plane of the substrate and having a cubic crystal structure;
a stack provided on a surface of the first superconductor film and including a second superconductor film, a first insulator film, and a third superconductor film each having a cubic crystal structure;
a second insulator film covering a side surface of the stack; and
a fourth superconductor film in contact with the third superconductor film, in which
the stack forms a Josephson junction, and
the first superconductor film has a lattice constant of a magnitude between a lattice constant of the substrate and a lattice constant of the second superconductor film, and
a [100] direction of each of the first superconductor film, the second superconductor film, the first insulator film, and the third superconductor film is parallel to a [100] direction of the substrate, and
a [001] direction of each of the first superconductor film, the second superconductor film, the first insulator film, and the third superconductor film is parallel to a [001] direction of the substrate.

### (Supplementary note 11)

A quantum device including:
a substrate having a cubic crystal structure;
a first superconductor film provided on a (111) plane of the substrate and having a cubic crystal structure;
a stack provided on a surface of the first superconductor film and including a second superconductor film, a first insulator film, and a third superconductor film each having a cubic crystal structure;
a second insulator film covering a side surface of the stack; and
a fourth superconductor film in contact with the third superconductor film, in which
the stack forms a Josephson junction, and
the first superconductor film has a lattice constant of a magnitude between a lattice constant of the substrate and a lattice constant of the second superconductor film, and
a [111] direction of each of the first superconductor film, the second superconductor film, the first insulator film, and the third superconductor film is parallel to a [111] direction of the substrate, and
a [11-2] direction of each of the first superconductor film, the second superconductor film, the first insulator film, and the third superconductor film is parallel to a [11-2] direction of the substrate.

### (Supplementary note 12)

The quantum device according to supplementary note 10 or 11, in which
a lattice mismatch degree between the first superconductor film and the second superconductor film is less than 10%.

### (Supplementary note 13)

The quantum device according to any one of supplementary notes 10 to 12, in which
the substrate is a Si substrate,
the second superconductor film and the third superconductor film are each an Al film, and
the first insulator film is an AlN film.

### (Supplementary note 14)

The quantum device according to any one of supplementary notes 10 to 13, in which
the first superconductor film is a TiN film, a NbN film, or a TaN film.

### (Supplementary note 15)

The quantum device according to any one of supplementary notes 10 to 14, in which
the second insulator film is an AlN film.

### (Supplementary note 16)

The quantum device according to any one of supplementary notes 10 to 15, in which
the fourth superconductor film is a NbTiN film, a Nb film, a Ta film, or a NbN film.

## Claims

1. A method of manufacturing a quantum device, the method comprising:
sequentially forming a first superconductor film, a second superconductor film, a first insulator film, and a third superconductor film each having a cubic crystal structure on a (100) plane or a (111) plane of a substrate having a cubic crystal structure by an epitaxial growth method;
forming a stack including the second superconductor film, the first insulator film, and the third superconductor film by patterning the second superconductor film, the first insulator film, and the third superconductor film;
patterning the first superconductor film using the stack as a mask;
wet etching a side surface of the stack after patterning the first superconductor film;
forming a second insulator film covering the wet etched side surface of the stack; and
forming a fourth superconductor film in contact with the third superconductor film after forming the second insulator film, wherein
the stack forms a Josephson junction, and
the first superconductor film has a lattice constant of a magnitude between a lattice constant of the substrate and a lattice constant of the second superconductor film.

2. The manufacturing method according to claim 1, further comprising:
forming a third insulator film covering a surface of the third superconductor film before forming the stack; and
removing the third insulator film after forming the second insulator film and before forming the fourth superconductor film.

3. The manufacturing method according to claim 2, wherein
film formation of the first superconductor film, the second superconductor film, the first insulator film, the third superconductor film, and the third insulator film is continuously performed while holding the substrate in a vacuum chamber.

4. The manufacturing method according to any of the preceding claims, wherein
a lattice mismatch degree between the first superconductor film and the second superconductor film is less than 10%.

5. The manufacturing method according to any of the preceding claims, wherein
the substrate is a Si substrate,
the second superconductor film and the third superconductor film are each an Al film, and
the first insulator film is an AlN film.

6. The manufacturing method according to any of claims 1 to 4, wherein
the first superconductor film is a TiN film, a NbN film, or a TaN film.

7. The manufacturing method according to any of claims 1 to 4 or claim 6, wherein
the second insulator film is an AlN film.

8. The manufacturing method according to any of claims 1 to 4 or claim 6 or claim 7, wherein
the fourth superconductor film is a NbTiN film, a Nb film, a Ta film, or a NbN film.

9. The manufacturing method according to claim 1, wherein
the second insulator film is formed in a state where a resist to be used in wet etching the side surface of the stack is left, and the second insulator film deposited on the resist is removed together with the resist to pattern the second insulator film.

10. A quantum device comprising:
a substrate having a cubic crystal structure;
a first superconductor film provided on a (100) plane or a (111) plane of the substrate and having a cubic crystal structure;
a stack provided on a surface of the first superconductor film and including a second superconductor film, a first insulator film, and a third superconductor film each having a cubic crystal structure;
a second insulator film covering a side surface of the stack; and
a fourth superconductor film in contact with the third superconductor film, wherein
the stack forms a Josephson junction,
the first superconductor film has a lattice constant of a magnitude between a lattice constant of the substrate and a lattice constant of the second superconductor film,
if the first superconductor film is provided on the (100) plane:
a [100] direction of each of the first superconductor film, the second superconductor film, the first insulator film, and the third superconductor film is parallel to a [100] direction of the substrate; and
a [001] direction of each of the first superconductor film, the second superconductor film, the first insulator film, and the third superconductor film is parallel to a [001] direction of the substrate, and
if the first superconductor film is provided on the (111) plane:
a [111] direction of each of the first superconductor film, the second superconductor film, the first insulator film, and the third superconductor film is parallel to a [111] direction of the substrate; and
a [11-2] direction of each of the first superconductor film, the second superconductor film, the first insulator film, and the third superconductor film is parallel to a [11-2] direction of the substrate.
